# NEUE EUROPÄISCHE PATENTSCHRIFT

(11) **EP 2 133 704 B2**
(45) Veröffentlichungstag und Bekanntmachung des Hinweises auf die Entscheidung über den Einspruch: **02.12.2015**
(45) Hinweis auf die Patenterteilung: 31.08.2011
(21) Anmeldenummer: 08010691.7
(22) Anmeldetag: 12.06.2008
(51) Int. Cl.: G01R 31/06, G01R 31/12

(54) **Prüfanordnung zur Wechselspannungsprüfung von elektrischen Hochspannungskomponenten**
Test assembly for AC testing of electric high voltage components
Dispositif d'essai pour des composants électriques à haute tension par courant alternatif

(43) Veröffentlichungstag der Anmeldung: 16.12.2009
(73) Patentinhaber: ABB Technology AG, 8050 Zürich (CH)
(72) Erfinder: Werle Peter, 29664 Walsrode (DE); Steiger, Matthias, 06779 Schierau (DE); Wohlfarth, Jürgen, 06114 Halle (DE)
(74) Vertreter: Kock, Ina

(56) Entgegenhaltungen:
- DE-A1- 2 328 375
- US-A- 2 551 841
- US-A- 4 427 898
- US-A- 4 535 253
- US-B1- 6 586 697
- WINTER A ET AL: "A mobile transformer test system based on a stativ frequency converter" INTERNET CITATION, 4. September 2007 (2007-09-04), XP002500564 [gefunden am 2007-09-04]
- LOPEZ-ROLDAN ET AL: "Mobile Substations: Application, Engineering and Structural Dynamics" PES TD 2005/2006 MAY 21-24, 2006, PISCATAWAY, NJ, USA,IEEE, 1. Januar 2006 (2006-01-01), Seiten 951-956, XP031101946 ISBN: 978-0-7803-9194-9
- JOSE LOPEZ-ROLDAN ET AL: "How to Achieve a Rapid Deployment of Mobile Substations and to Guarantee Its Integrity During Transport" IEEE TRANSACTIONS ON POWER DELIVERY, IEEE SERVICE CENTER, NEW YORK, NY, US, Bd. 23, Nr. 1, 1. Januar 2008 (2008-01-01), Seiten 196-202, XP011197613 ISSN: 0885-8977
- WINTER A. ET AL.: 'A New Generation of On-Site Test Systems for Power Transformers' IEEE 10 Juni 2008, Seiten 478 - 482
- EKLUND L. ET AL.: 'Tranformation vor Ort' ABB TECHNIK April 2007, Seiten 46 - 48
- EKLUND L. ET AL.: 'Increase transformer reliability and availability: From condition assessment to On-Site Repair' POWER-GEN MIDDLE EAST April 2007, Seiten 1 - 17
- URSPRüNGLICHER DATEINAME: E6.PDF

## Beschreibung

Die Erfindung betrifft eine Prüfanordnung zur Wechselspannungsprüfung von elektrischen Hochspannungskomponenten mit wenigstens einem Wechselrichter, mit wenigstens einem Prüftransformator und mit wenigstens einer Hochspannungsdrossel als Prüfkomponenten, wobei wenigstens die genannten Prüfkomponenten in einem gemeinsamen quaderförmigen Behälter angeordnet sind.

Es ist allgemein bekannt, dass Hochspannungskomponenten, wie beispielsweise Leistungstransformatoren, einem Alterungsprozess unterworfen sind, welcher insbesondere die elektrische Isolation betrifft. Von daher sind zur Sicherstellung eines fehlerfreien Betriebes eines elektrischen Energieverteilungsnetzes mit derartigen Hochspannungskomponenten in bestimmten Zeitintervallen Prüfungen, insbesondere der Leistungstransformatoren, sinnvoll. Eine derartige Prüfung ist auch nach einer Reparatur oder Wartung eines Transformators sinnvoll bzw. erforderlich. Derartige Prüfungen geben Aufschluss über den Zustand beispielsweise der Isolation und ermöglichen auch die Detektion anderer Fehler der betreffenden Hochspannungskomponente.

Hochspannungskomponenten wie Leistungstransformatoren weisen ein sehr hohes Gewicht auf, je nach elektrischer Nennleistung auch über 100t. Ein Transport eines derartigen innerhalb eines elektrischen Energieverteilungsnetzes eingebauten Leistungstransformators in ein fest installiertes Prüffeld, in welchem dieser mittels einer Wechselspannungsprüfung geprüft werden könnte, ist aufgrund des hohen Transportaufwandes für den jeweiligen Leistungstransformator praktisch ausgeschlossen. Zudem ist in den seltensten Fällen genügend Redundanz in einem Energieverteilungsnetz vorhanden, dass ein Leistungstransformator ohne Beeinträchtigung des Netzbetriebes ausgebaut werden könnte.

Aus diesem Grund erfolgen derartige Wechselspannungsprüfungen von Leistungstransformatoren zumeist vor Ort. Die Prüfanordnung mit Wechselspannungsgenerator sowie weiteren für die Prüfung benötigten Komponenten wie Hochspannungsdrossel, Spannungsteiler, Mess- und Auswertevorrichtungen wird in mehreren Baugruppen zu dem Ort, an dem sich der zu prüfende Leistungstransformator befindet, transportiert und dort zu einer Prüfanordnung montiert. Insbesondere die Hochspannungsdrossel, welche für eine Resonanzprüfung zur Bildung eines Resonanzschwingkreises mit dem Prüfling benötigt wird, kann mit einer Höhe von beispielsweise 2,5m und einem Innendurchmesser von beispielsweise 1m eine Prüfkomponente von beachtlicher Größe darstellen. Auch der Spannungsteiler, welcher zur Messung der hohen Spannungen von beispielsweise bis zu mehreren 100kV im Resonanzschwingkreis benötigt wird, ist eine Komponente mit ähnlicher Höhe.

Bei der Durchführung einer Wechselspannungsprüfung ist darauf zu achten, dass die Komponenten der Prüfanordnung aufgrund der hohen auftretenden Spannungen einen genügend großen Abstand zueinander und zu angrenzendem Erdpotential aufweisen.

So ist aus der Veröffentlichung "A mobile transformer test system based on a static frequency converter" (Winter et al 15th International Symposium on High Voltage Engineering, University of Lljubljana, Elektroinstitut Milan Vidmar, Lljubljana, Slovenia, August 27-31, 2007*)* bekannt, statische Prüfsysteme für die Wechselspannungsprüfung von Transformatoren auch mobil auszuführen In dem Dokument US 6586671 ist eine mittels Tieflader transportierbare Schaltanordnung bekannt, welche auch transportierbare zugehörige elektrische Gerätschaften umfasst.

Nachteilig ist, dass die Montage der verschiedenen Baugruppen vor Ort mit einem erheblichen Zeitaufwand verbunden ist. Insbesondere die Positionierung und Montage einer Hochspannungsdrossel oder eines Spannungsteilers sind sehr zeitaufwändig.

Ausgehend von diesem Stand der Technik ist es Aufgabe der Erfindung, eine Prüfanordnung anzugeben, welche einen geringeren Platzbedarf aufweisen und in einer verringerten Anzahl von Baugruppen transportierbar sind

Diese Aufgabe wird erfindungsgemäß gelöst durch eine Prüfanordnung mit den im Anspruch 1 angegebenen Merkmalen.

Demgemäß kennzeichnet sich die Prüfanordnung der eingangs genannten Art unter anderen dadurch, dass die wenigstens eine Hochspannungsdrossel mittels einer Bewegungsvorrichtung durch wenigstens eine Öffnung an einer Begrenzungsfläche des Behälters zumindest teilweise aus diesem bewegbar ist.

Die Isolationsabstände zwischen der Hochspannungsdrossel und weiteren angrenzenden Komponenten beziehungsweise angrenzendem Erdpotential sind hierdurch vorteilhaft steigerbar. Somit ist bei einer ersten Anordnungsvariante der Hochspannungsdrossel innerhalb des Behälters eine besonders platzsparende Anordnung gegeben, welche den Transport der Prüfanordnung vereinfacht. Bei einer weiteren Anordnungsvariante der Hochspannungsdrossel außerhalb des Behälters sind die Isolationsabstände erhöht, was den Betrieb der Anordnung ermöglicht oder zumindest isolationstechnisch sicherer gestaltet. Der Wechsel zwischen den Anordnungsvarianten erfolgt durch die Bewegungsvorrichtung in besonders einfacher Form.

In vorteilhafter Weise wird durch die kompakte Anordnung der Drossel innerhalb des Behälters ein Transport des Behälters und der in ihm angeordneten Komponenten der Prüfanordnung vereinfacht.

In einer weiteren Ausgestaltung der Prüfanordnung ist ein Spannungsteiler durch wenigstens eine weitere Öffnung an einer Begrenzungsfläche des Behälters mittels einer weiteren Bewegungsvorrichtung zumindest teilweise aus diesem bewegbar.

Ein Spannungsteiler, welcher vorzugsweise in einer Resonanzkreisverschaltung der Prüfanordnung verwendet wird, ist eine Komponente ähnlicher Höhe wie eine Hochspannungsdrossel mit ähnlichen isolationstechnischen Anforderungen. Die Platzvorteile, welche sich für eine aus dem Behälter bewegbare Hochspannungsdrossel ergeben, erschließen sich demgemäß auch für einen aus dem Behälter bewegbaren Spannungsteiler.

In einer Variante der Prüfanordnung ist die wenigstens eine und/oder die wenigstens eine weitere Öffnung an jeweils einer senkrechten Begrenzungsfläche des Behälters befindlich und die Bewegungsvorrichtung und/oder die weitere Bewegungsvorrichtung wirkt vorwiegend in horizontaler Richtung.

Somit ist ein horizontales Herausbewegen der Hochspannungsdrossel und/oder des Spannungswandlers zu einer Seite oder einer Stirnfläche des Behälters ermöglicht. Ein Beispiel für eine geeignete Bewegungsvorrichtung ist eine Teleskopschiene.

In einer bevorzugten Ausgestaltung der erfindungsgemäßen Anordnung ist die horizontal wirkende Bewegungsvorrichtung beziehungsweise die weitere horizontal wirkende Bewegungsvorrichtung mit der zumindest teilweise aus dem Behälter bewegten Hochspannungsdrossel beziehungsweise dem Spannungsteiler nach unten mittels jeweils einer Abstützvorrichtung abstützbar. Eine derartige Abstützvorrichtung ist - ähnlich wie bei einem gegen Kippen zu sichernden mobilen Kran - beispielsweise eine in einem senkrechten Gewindekanal angeordnete Spindel, welche durch eine Drehbewegung derart längs des Gewindekanals bewegbar ist, dass sie eine Stütze zwischen der Bewegungsvorrichtung und dem Untergrund bildet. Es ist aber auch eine Vielzahl von weiteren dem Fachmann bekannten Ausführungsformen einer Abstützvorrichtung möglich.

Die an der Aussenkante des Behälters wirkende maximale Drehmomentbelastung der jeweiligen Bewegungsvorrichtung ist dadurch reduziert und deren Konstruktion wird vereinfacht. Zudem steigt die Standsicherheit des Behälters.

In einer Variante der Prüfanordnung ist die wenigstens eine beziehungsweise wenigstens eine weitere Öffnung an der oberen Begrenzungsfläche des Behälters befindlich und die Bewegungsvorrichtung wirkt vorwiegend in vertikaler Richtung. Somit ist ein vertikales Herausbewegen der Hochspannungsdrossel beziehungsweise des Spannungsteilers durch die Dachseite des Behälters ermöglicht. Ein Beispiel für eine geeignete jeweilige Bewegungsvorrichtung ist eine hydraulische Hebevorrichtung.

Vorteilhafterweise ist die wenigstens eine und/oder wenigstens eine weitere Öffnung des Behälters verschließbar. Bei einem Transport des Behälters mit geschlossenen Öffnungen sind die in ihm befindlichen Komponenten der Prüfanordnung somit besser geschützt.

In einer bevorzugten Ausgestaltung der Prüfanordnung sind die Bewegungsvorrichtung und/oder die weitere Bewegungsvorrichtung mit jeweils einem Antrieb versehen. Der Bewegungsvorgang wird dadurch vereinfacht.

In einer vorteilhaften Ausgestaltung der Prüfanordnung ist der Behälter mit einer Transportvorrichtung verbunden, welche sie tragende Räder aufweist, beispielsweise mit einem LKW mit Auflieger. Der Transport der Prüfanordnung wird dadurch vereinfacht.

Besonders bevorzugt ist in diesem Zusammenhang die Ausgestaltung des Behälters als Container mit Standardabmessung, beispielsweise als Container mit 40 Fuß Länge. Dieser ist in einer weiteren Variante gemäß CSC (Container Safety Convention) zugelassen und somit in jeder beliebigen Position innerhalb eines Containerstapels auf einem Containerschiff platzierbar. Hierdurch wird die Transportierbarkeit der Prüfanordnung noch weiter erhöht.

In einer bevorzugten Ausführungsform der Prüfanordnung weist der Behälter an seinem ersten Ende einen innen liegenden Bereich auf, in welchem Messvorrichtungen und/oder Auswertevorrichtungen angeordnet sind.

Eine Messvorrichtung ist beispielsweise dafür vorgesehen, den Spannungsverlauf während einer Wechselspannungsprüfung zu messen und zu erfassen, wobei eine mittels des Spannungsteilers auf ein niedriges Spannungsniveau reduzierte Spannung gemessen wird. Eine Auswertevorrichtung ist dafür vorgesehen, die gemessenen und erfassten Spannungswerte auszuwerten und beispielsweise eine Aussage über den Zustand der Isolation der geprüften Hochspannungskomponente, beispielsweise einem Leistungstransformator, zu geben.

In einer bevorzugten Ausführungsform der Prüfanordnung sind die Prüfkomponenten zumindest teilweise mittels isolierter Hochspannungskabel elektrisch miteinander verbunden. Der aus Isolationsgründen bedingte Mindestabstand zwischen den Prüfkomponenten ist dadurch weiter reduzierbar.

In einer weiteren Ausführungsform der erfindungsgemäßen Prüfanordnung umfasst diese einen elektrischen Resonanzschwingkreis mit wenigstens der Hochspannungsdrossel und einer zu prüfenden Hochspannungskomponente sowie den damit verschalteten Spannungsteiler.

Ein Resonanzschwingkreis ist eine einfache Möglichkeit, hohe Prüfspannungen zu erzeugen. Aufgrund der Höhe der erzeugten Prüfspannungen von beispielsweise 500kV beträgt die isolationstechnisch erforderliche Länge eines entsprechenden Spannungsteilers typischerweise etwa 2,5m, wie dem Fachmann jedoch bekannt ist. Diese Länge entspricht in etwa auch der Länge einer bevorzugten Ausführungsform einer erfindungsgemäßen Hochspannungsdrossel, welche beispielsweise einen lichten Innendurchmesser von ca. 1 m aufweist.

Erfindungsgemäß ist der Resonanzschwingkreis mittels des Wechselrichters und des mit diesem elektrisch verbundenen Prüftransformators anregbar. Die elektrische Leistung eines derartigen Wechselrichters beträgt beispielsweise mehrere 100kVA . Der Wechselrichter erzeugt eine Wechselspannung variabler Frequenz, wobei diese auf die Resonanzfrequenz des Schwingkreises geregelt ist. Diese ist zunächst von der Kapazität bzw. Induktivität des Prüflings abhängig, aber auch von der Induktivität der Hochspannungsdrossel und der Kapazität des Spannungsteilers. Die Prüfkomponenten sind derart zu bemessen, dass die Resonanzfrequenz bei typischen Prüflingen ca. 100Hz nicht übersteigt.

In einer weiteren Variante der Prüfanordnung weist die Hochspannungsdrossel wenigstens einen elektrischen Leiter auf, welcher in einer Vielzahl von Windungen um eine Wickelachse angeordnet ist, wobei die Windungen radial einen Innenraum längs der Wickelachse umschließen, wobei in diesem Innenraum wenigstens ein Kondensator angeordnet ist, durch welchen zusammen mit wenigstens einem weiteren mit diesem elektrisch verbundenen Kondensator die Funktionalität des Spannungsteilers gebildet ist.

Bei einer derartigen Anordnung sind insbesondere isolationstechnische Anforderungen zwischen der Wicklung der Hochspannungsdrossel und dem innen angeordneten Kondensator zu erfüllen. Demgemäß ist es zweckmäßig, einen Wickelkörper, um den die Windungen der Hochspannungsdrossel üblicherweise angeordnet sind, in einem Isolationsmaterial von hinreichender Dicke, je nach Spannungsbeanspruchung beispielsweise einige Zentimeter, auszuführen.

Die Anordnung eines Kondensators im Innenraum einer Hochspannungsdrossel, beispielsweise als Bestandteil eines Spannungsteilers, nutzt in vorteilhafter Weise den dort zur Verfügung stehenden Platz.

In einer weiteren Ausgestaltung der Prüfanordnung ist wenigstens ein während eines Prüfvorgangs notwendiger Verfahrensschritt oder der gesamte Prüfvorgang mittels einer Fernbedienung initiierbar. Die Verwendung einer Fernbedienung reduziert den benötigten Montageaufwand für die Prüfanordnung in vorteilhafter Weise und ermöglicht zudem eine einfachere Durchführung einer Wechselspannungsprüfung.

Weitere vorteilhafte Ausgestaltungsmöglichkeiten sind den weiteren abhängigen Ansprüchen zu.entnehmen.

Anhand der in den Zeichnungen dargestellten Ausführungsbeispiele sollen die Erfindung, weitere Ausführungsformen und weitere Vorteile näher beschrieben werden.

Es zeigen:
- Fig. 1: eine Draufsicht auf erste Prüfanordnung,
- Fig. 2: eine Seitenansicht auf zweite Prüfanordnung sowie
- Fig. 3: ein Übersichtsbild eines Resonanzschwingkreises

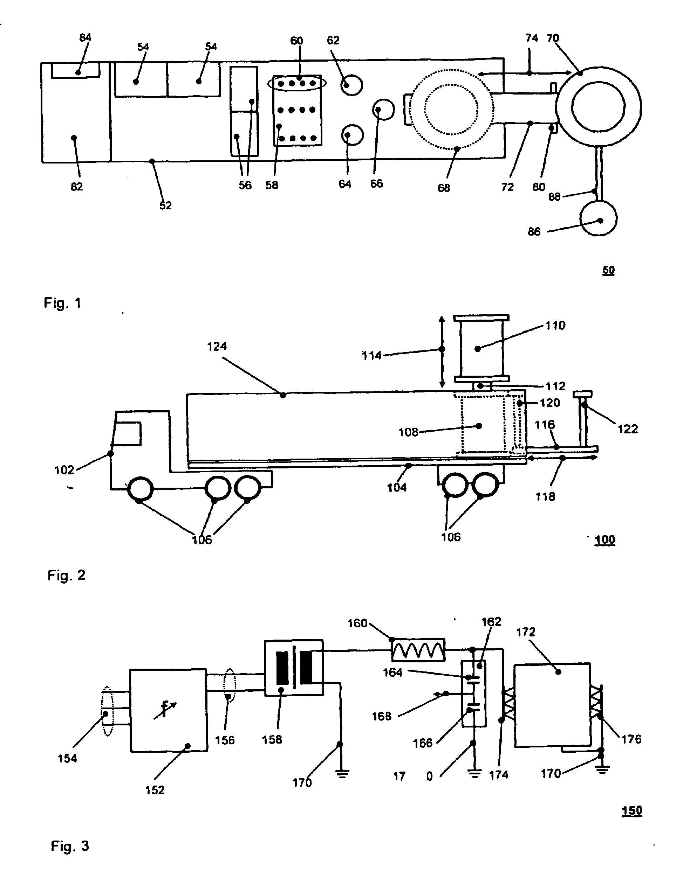

Fig. 1 zeigt eine Draufsicht auf erste Prüfanordnung 50. Auf der Bodenfläche eines quaderförmigen ersten Behälters 52, dessen Dachfläche hier nicht gezeigt ist, sind mehrere Prüfkomponenten eines erfindungsgemäßen Prüfsystems 50 dargestellt.

Zwei Wechselrichteranordnungen 54 sind im vorderen, in der Fig. links dargestellten, Bereich des ersten Behälters angeordnet, welche mit einer nicht gezeigten Spannungsversorgung von beispielsweise 400V, 3phasig, 50 Hz verbunden sind. Die jeweiligen Verbindungsleitungen zwischen den einzelnen Komponenten sind in dieser Darstellung nicht gezeigt.

Im Falle einer 3-phasigen Wechselspannungsprüfung wird jede der drei erzeugten Wechselspannungen über den ersten Prüftransformator 58 auf ein höheres Spannungsniveau transformiert und einem nicht gezeigten Prüfling zugeführt, wobei die jeweiligen Spannungen mit Spannungwandlern 62, 64, 66 zu Messzwecken auf eine niedrigere, messbare Spannung herunterformbar sind. Die Spannungswandler 62, 64, 66 haben beispielsweise eine Höhe von ca. 1m und sind beispielsweise derart angeordnet, dass die Isolationsabstände innerhalb des ersten Behälters 52 und zu den Behälterwänden eine maximale Spannung von 220kV zulassen. Diese Spannung ist für derartige 3-phasige Wechselspannungsprüfungen hinreichend. Im Messraum 82 im linken dargestellten Bereich des ersten Behälters 52 sind Mess- Auswertevorrichtungen 84 vorgesehen, mit welchen zugeführte Messsignale erfasst, gespeichert und ausgewertet werden können. Ein Filter 56 ist dafür vorgesehen, die vom ersten Wechselrichter 54 erzeugten Wechselspannungen gegebenenfalls zu glätten. Weiterhin sind auch Vorrichtungen zur Blindleistungskompensation erfindungsgemäß anordenbar, wobei die Blindleistungskompensation gegebenenfalls auch durch den Filter 56 erfolgen kann.

Eine erste Hochspannungsdrossel 68, 70 ist in gestrichelter Form im rechten inneren Bereich des ersten Behälters 52 in einer ersten Position angedeutet. In dieser ersten Position sind die für den Betrieb der ersten Hochspannungsdrossel 68, 70 notwendigen Isolationsabstände, beispielsweise zu den Seitenwänden des ersten Behälters 52 nicht eingehalten. Diese erste Position innerhalb des ersten Behälters 52 ist aber für Transportzwecke der Prüfanordnung geeignet.

Im Falle einer Resonanzprüfung wird die erste Hochspannungsdrossel 68, 70 in einem Resonanzschwingkreis mit dem Prüfling verschaltet. Eine Resonanzprüfung erfolgt 1-phasig, es wird also nur eine einzige Wechselspannung vom ersten Wechselrichter 54 erzeugt und es wird nur eine Hochspannungsdrossel 68, 70 benötigt. Die bei einer Resonanzprüfung auftretenden Spannungen sind oftmals höher, als die bei einer normalen Wechselspannungsprüfung, beispielsweise 500kV, weshalb die Spannungswandler 62, 64, 66 nicht zur direkten Verwendung geeignet sind.

Die erste Hochspannungsdrossel ist nunmehr in der zweiten Position 70 anzusehen, in welche sie mittels der ersten Bewegungsvorrichtung 72 verbracht wurde, beispielsweise einer ausfahrbaren Teleskopschiene. Die erste Bewegungsvorrichtung 72 ist mittels einer Stützvorrichtung 80 gegenüber der Standfläche des ersten Behälters 52 abgestützt. Eine überhöhte Knickbeanspruchung der ersten Bewegungsvorrichtung 72 ist dadurch vermieden. Neben der ausgefahrenen ersten Hochspannungsdrossel 70 ist ein erster Spannungsteiler 86 dargestellt, welcher über eine Verbindung 88 elektrisch mit der ersten Hochspannungsdrossel 70 verbunden ist. In dieser Variante ist der erste Spannungsteiler 86 nicht erfindungsgemäß mittels einer Bewegungsvorrichtung sondern manuell aus dem ersten Behälter 52 verbracht und angeschlossen worden.

Fig. 2 zeigt eine Seitenansicht auf zweite Prüfanordnung 100. Eine zweite Hochspannungsdrossel in einer ersten Position 108 ist mit einer gestrichelten Linie innerhalb eines zweiten Behälters 124 angedeutet, wobei dieser vorzugsweise als 40-Fuß Container ausgeführt ist. Der zweite Behälter 124 ist auf einer ersten 102 und einer zweiten 104 Transportvorrichtung mit dazugehörigen Rädern 106 dargestellt, einem LKW mit einem Auflieger. Durch die Position innerhalb der Begrenzungen des zweiten Behälters 124 ist die zweite Hochspannungsdrossel 108 vorteilhaft geschützt transportierbar. Der zweite Behälter 124 ist beim Transport zu Schutzzwecken der Prüfanordnung vorzugsweise an allen sechs Seitenwänden verschlossen. Vor einem Bewegungsvorgang der zweiten Hochspannungsdrossel 108, 110 durch die äußere Begrenzung des zweiten Behälters 124 ist an diesem demgemäß zuvor eine Öffnung herzustellen, durch welche die zweite Hochspannungsdrossel 108, 110 von innen nach außen bewegbar ist. Hiezu ist wenigstens ein Segment der betreffenden Begrenzungswand zu entfernen oder zu verschieben, vorzugsweise mit einem Antriebsmechanismus oder aber auch manuell.

Weiterhin dargestellt ist die zweite Hochspannungsdrossel in einer zweiten Position 110 außerhalb des zweiten Behälters 124. Diese zweite Position ist von der ersten Position mittels einer zweiten Bewegungsvorrichtung 112, beispielsweise einer Hubvorrichtung, erreichbar. Die Bewegungsrichtung verläuft in der dargestellten Fig. senkrecht und ist mit dem Pfeil 114 gekennzeichnet. Es ist aber auch eine Bewegungsrichtung der Hochspannungsdrossel in horizontaler Richtung durch eine Seiten- oder Stirnfläche des Behälters 124 denkbar.

Analog zur zweiten Hochspannungsdrossel 108, 110 ist auch ein zweiter Spannungsteiler in einer inneren Position 120 und einer äußeren Position 122 dargestellt. Die Bewegungsrichtung verläuft in der dargestellten Fig. waagerecht und ist mit dem Pfeil 118 gekennzeichnet. Es ist aber auch eine Bewegungsrichtung des zweiten Spannungsteilers 120, 122 in vertikaler Richtung durch die Dachfläche des zweiten Behälters 124 denkbar.

Fig. 3 zeigt ein schematisches Übersichtsschaltbild über einen Resonanzschwingkreis 150, zu welchem ein Teil der Prüfkomponenten für Prüfungen mit besonders hohen Spannungen zusammenschaltbar ist. Ein derartiger Resonanzschwingkreis ist einphasig, d.h. bei denen in Fig. 1 teilweise 3-phasig angedeuteten Prüfkomponenten wie Prüftransformator oder Spannungswandlern wird in dieser Anordnung jeweils nur-eine Phase benutzt.

Ein Wechselrichter 152 ist über seine Eingänge 154 3-phasig mit einer Spannungsversorgung vor Ort verbunden, beispielsweise 400V, 50Hz. An den Ausgängen 156 des Wechselrichters 152, welche mit den Anschlüssen der Unterspannungsseite eines zweiten Prüftransformators 158 verbunden sind, liegt während des Betriebes eine geregelte Wechselspannung an, welche vorzugsweise mit nicht dargestellten Filtern geglättet wird. Die Frequenz der Wechselspannung ist derart geregelt, dass der Resonanzschwingkreis in seiner Resonanzfrequenz angeregt wird. Der Resonanzschwingkreis weist in der Hauptsache eine dritte Hochspannungsdrossel 160, einen Prüfling 172 und einen kapazitiven dritten Spannungsteiler 162 auf. Die Komponenten sind derart aufeinander abgestimmt, dass sich eine Resonanzfrequenz von etwas über den üblichen 50Hz Netzfrequenz ergibt, beispielsweise 150Hz, wobei diese insbesondere von den Kenndaten des zu testenden Prüflings abhängt. Der Prüfling 172 ist in der dargestellten Fig. ein 3-phasiger Leistungstransformator, dessen unterspannungsseitigen Anschlüsse jeweils mit einer Erdung 170 verbunden sind und dessen oberspannungsseitigen Anschlüsse 174 elektrisch parallel zueinander im Schwingkreis verschaltet sind.

In einer derartigen Anordnung sind Spannungen bis zu mehreren 100kV erzeugbar, welche mit dem die beiden Kondensatoren 164 und 166 aufweisenden Spannungsteiler 162 messbar sind. Die Spannung ist Führungsgröße für die Frequenzregelung des Wechselrichters 152.

### Bezugszeichenliste

- 50: Draufsicht auf erste Prüfanordnung
- 52: erster Behälter
- 54: erster Wechselrichter
- 56: Filter
- 58: erster Prüftransformator
- 60: Anschlüsse Prüftransformator
- 62: erster Spannungswandler
- 64: zweiter Spannungswandler
- 66: dritter Spannungswandler
- 68: erste Hochspannungsdrossel in erster Position
- 70: erste Hochspannungsdrossel in zweiter Position
- 72: erste Bewegungsvorrichtung
- 74: erste Bewegungsrichtung
- 80: Stützvorrichtung
- 82: Messraum
- 84: Mess- / Auswertevorrichtung
- 86: erster Spannungsteiler
- 88: Verbindung
- 100: Seitenansicht auf zweite Prüfanordnung
- 102: erste Transportvorrichtung
- 104: zweite Transportvorrichtung
- 106: Rad
- 108: zweite Hochspannungsdrossel in erster Position
- 110: zweite Hochspannungsdrossel in zweiter Position
- 112: zweite Bewegungsvorrichtung
- 114: zweite Bewegungsrichtung
- 116: dritte Bewegungsvorrichtung
- 118: dritte Bewegungsrichtung
- 120: zweiter Spannungsteiler in erster Position
- 122: zweiter Spannungsteiler in zweiter Position
- 124: zweiter Behälter
- 150: Übersichtsbild Resonanzschwingkreis
- 152: zweiter Wechselrichter
- 154: Eingänge des zweiten Wechselrichters
- 156: Ausgänge des zweiten Wechselrichters
- 158: zweiter Prüftransformator
- 160: dritte Hochspannungsdrossel
- 162: dritter Spannungsteiler
- 164: vierter Kondensator
- 166: fünfter Kondensator
- 168: Messspannung
- 170: Erdung
- 172: Leistungstransformator
- 174: kurzgeschlossene oberspannungsseitige Anschlüsse
- 176: kurzgeschlossene unterspannungsseitige Anschlüsse

## Patentansprüche

1. Prüfanordnung (50, 100) zur Wechselspannungsprüfung von elektrischen Hochspannungskomponenten (172), umfassend
• wenigstens einen Wechselrichter (54, 152), wenigstens einen Prüftransformator (58, 158) und wenigstens eine Hochspannungsdrossel (68, 70, 108, 114, 160) als Prüfkomponenten,
• einen gemeinsamen quaderförmigen Behälter (52,124), in welchem wenigstens die genannten Prüfkomponenten angeordnet sind,
• eine Bewegungsvorrichtung (72, 112),
wobei
die wenigstens eine Hochspannungsdrossel (68,70, 108, 110, 160) mittels der Bewegungsvorrichtung (72, 112) durch wenigstens eine Öffnung an einer Begrenzungsfläche des Behälters (52, 124) zumindest teilweise aus diesem bewegbar ist und dadurch ein Wechsel zwischen einer ersten Anordnungsvariante der Hochspannungsdrossel (68, 70, 108,114,160) innerhalb des quaderförmigen Behälters (52,124) und einer zweiten Anordnungsvariante mit einem genügendem Isolationsabstand zur Durchführung der Wechselspannungsprüfung ermöglicht ist,
**dadurch gekennzeichnet, dass** diese eine weitere Bewegungsvorrichtung (116) und einen Spannungsteiler (86, 122, 162) umfasst, welcher durch wenigstens eine weitere Öffnung an einer Begrenzungsfläche des Behälters (52, 124) mittels der weiteren Bewegungsvorrichtung (116) zumindest teilweise aus diesem bewegbar ist.

2. Prüfanordnung nach Anspruche 1, **dadurch gekennzeichnet, dass** die wenigstens eine und/oder die wenigstens eine weitere Öffnung an jeweils einer senkrechten Begrenzungsfläche des Behälters (52, 124) befindlich ist und die Bewegungsvorrichtung (72,112) und/oder die weitere Bewegungsvorrichtung (116) vorwiegend in horizontaler Richtung (74, 116) wirkt.

3. Prüfanordnung nach Anspruch 2, **dadurch gekennzeichnet, dass** die Bewegungsvorrichtung (72,112) und/oder die weitere Bewegungsvorrichtung (116) mit der zumindest teilweise aus dem Behälter (52, 124) bewegten Hochspannungsdrossel (68,70,108, 110,160) beziehungsweise mit dem zumindest teilweise aus dem Behälter bewegten Spannungsteiler (86,122,162) nach unten mittels einer Stützvorrichtung (80) abstützbar ist.

4. Prüfanordnung nach Anspruch 1, **dadurch gekennzeichnet, dass** die wenigstens eine Öffnung und/oder die wenigstens eine weitere Öffnung an der oberen Begrenzungsfläche des Behälters (52, 124) befindlich ist und die Bewegungsvorrichtung (72, 112) und/oder die weitere Bewegungsvorrichtung (116) vorwiegend in vertikaler Richtung (114) wirkt.

5. Prüfanordnung nach einem der vorherigen Ansprüche, **dadurch gekennzeichnet, dass** die wenigstens eine Öffnung und/oder die wenigstens eine weitere Öffnung verschließbar ist.

6. Prüfanordnung nach einem der vorherigen Ansprüche, **dadurch gekennzeichnet, dass** die Bewegungsvorrichtung (72,112) und/oder die weitere Bewegungsvorrichtung (116) mit einem Antrieb versehen ist.

7. Prüfanordnung nach einem der vorherigen Ansprüche, **dadurch gekennzeichnet, dass** der Behälter (52, 124) mit einer Transportvorrichtung (102, 104) verbunden ist, welche ihn tragende Räder (106) aufweist.

8. Prüfanordnung nach einem der vorherigen Ansprüche, **dadurch gekennzeichnet, dass** der Behälter (52, 124) ein transportierbarer Container mit Standardabmessungen ist.

9. Prüfanordnung nach einem der vorherigen Ansprüche, **dadurch gekennzeichnet, dass** der Behälter (52, 124) einen innen liegenden Bereich (82) aufweist, in welchem Messvorrichtungen und/oder Auswertevorrichtungen (84) angeordnet sind.

10. Prüfanordnung nach einem der vorherigen Ansprüche, **dadurch gekennzeichnet, dass** die Prüfkomponenten, (54, 56, 58, 62, 64, 66, 68, 70, 86, 108, 110, 120, 122, 152, 158, 160, 162) zumindest teilweise mittels isolierten Hochspannungskabeln elektrisch miteinander verbunden sind.

11. Prüfanordnung nach einem der vorherigen Ansprüche, **dadurch gekennzeichnet, dass** diese einen elektrischen Resonanzschwingkreis (150) mit wenigstens der Hochspannungsdrossel (68, 70, 108, 110, 160) und einer zu prüfenden Hochspannungskomponente (172) sowie einen damit verschalteten Spannungsteiler (86,120, 122, 162) umfasst.

12. Prüfanordnung nach Anspruch 1, **dadurch gekennzeichnet, dass** der Resonanzschwingkreis (100) mittels des Wechselrichters (54,152) und des mit diesem elektrisch verbundenen Prüftransformators (58,158) anregbar ist.

13. Prüfanordnung nach einem der Ansprüche 1 oder 12, **dadurch gekennzeichnet, dass** die Hochspannungsdrossel (88, 70,108,114,180) wenigstens einen elektrischen Leiter aufweist, welcher in einer Vielzahl von Windungen um eine Wickelachse angeordnet ist, wobei die Windungen radial einen Innenraum längs der Winkelachse umschließen und dass in diesem Innenraum wenigstens ein Kondensator (164) angeordnet ist, durch welchen zusammen mit wenigstens einem weiteren mit diesem elektrisch verbundenen Kondensator (166) die Funktionalität des Spannungsteilers (162) gebildet ist.

14. Prüfanordnung nach einem der vorangegangenen Ansprüche, **dadurch gekennzeichnet, dass** wenigstens ein während eines Prüfvorgangs notwendiger Verfahrensschritt oder der gesamte Prüfvorgang mittels einer Fernbedienung initiierbar ist.

## Claims

1. Test arrangement (50, 100) for AC voltage testing of high-voltage electrical components (172), comprising
• at least one inverter (54, 152), at least one test transformer (58, 158) and at least one high-voltage inductor (68, 70, 108, 114, 160) as test components,
• a common cuboid container (52, 124), in which at least said test components are arranged,
• a movement apparatus (72, 112),
wherein the at least one high-voltage inductor (68, 70, 108, 110, 160) can be moved at least partially out of the container (52, 124) by means of the movement apparatus (72, 112) through at least one opening in a boundary surface of said container, and this enables a change between a first arrangement variant of the high-voltage inductor (68, 70, 108, 114, 160) within the cuboid container (52, 124) and a second arrangement variant with sufficient insulating clearance for performing the AC voltage testing, **characterized in that** said test arrangement comprises a further movement apparatus (116) and a voltage divider (86, 122, 162), which can be moved at least partially out of the container (52, 124) through at least one further opening in a boundary surface of said container by means of the further movement apparatus (116).

2. Test arrangement according to Claim 1, **characterized in that** the at least one and/or the at least one further opening is located in a respective perpendicular boundary surface of the container (52, 124), and the movement apparatus (72, 112) and/or the further movement apparatus (116) acts predominantly in the horizontal direction (74, 116).

3. Test arrangement according to Claim 2, **characterized in that** the movement apparatus (72, 112) and/or the further movement apparatus (116) with the high-voltage inductor (68, 70, 108, 110, 160) moved at least partially out of the container (52, 124) or with the voltage divider (86, 122, 162) moved at least partially out of the container can be supported at the bottom by means of a supporting apparatus (80).

4. Test arrangement according to Claim 1, **characterized in that** the at least one opening and/or the at least one further opening is located in the upper boundary surface of the container (52, 124), and the movement apparatus (72, 112) and/or the further movement apparatus (116) acts predominantly in the vertical direction (114).

5. Test arrangement according to one of the preceding claims, **characterized in that** the at least one opening and/or the at least one further opening can be closed.

6. Test arrangement according to one of the preceding claims, **characterized in that** the movement apparatus (72, 112) and/or the further movement apparatus (116) is provided with a drive.

7. Test arrangement according to one of the preceding claims, **characterized in that** the container (52, 124) is connected to a transport apparatus (102, 104) which has wheels (106) supporting said container.

8. Test arrangement according to one of the preceding claims, **characterized in that** the container (52, 124) is a transportable shipping container with standard dimensions.

9. Test arrangement according to one of the preceding claims, **characterized in that** the container (52, 124) has an internal region (82), in which measurement apparatuses and/or evaluation apparatuses (84) are arranged.

10. Test arrangement according to one of the preceding claims, **characterized in that** at least some of the test components (54, 56, 58, 62, 64, 66, 68, 70, 86, 108, 110, 120, 122, 152, 158, 160, 162) are connected electrically to one another by means of insulated high-voltage cables.

11. Test arrangement according to one of the preceding claims, **characterized in that** said test arrangement comprises an electrical resonant circuit (150) with at least the high-voltage inductor (68, 70, 108, 110, 160) and a high-voltage component (172) to be tested as well as a voltage divider (86, 120, 122, 162) connected thereto.

12. Test arrangement according to Claim 1, **characterized in that** the resonant circuit (100) can be excited by means of the inverter (54, 152) and the test transformer (58, 158), which is electrically connected thereto.

13. Test arrangement according to either of Claims 1 and 12, **characterized in that** the high-voltage inductor (88, 70, 108, 114, 180) has at least one electrical conductor, which is arranged in a large number of turns around a winding axis, the turns radially surrounding an interior along the winding axis, and **in that** at least one capacitor (164) is arranged in this interior, with the functionality of the voltage divider (162) being formed by said capacitor together with at least one further capacitor (166), which is electrically connected thereto.

14. Test arrangement according to one of the preceding claims, **characterized in that** at least one method step which is required during a test operation or the entire test operation can be initiated by means of remote control.

## Revendications

1. Arrangement de contrôle (50, 100) pour contrôler la tension alternative de composants électriques à haute tension (172), comprenant
* au moins un onduleur (54, 152), au moins un transformateur de contrôle (58, 158) et au moins une bobine à haute tension (68, 70, 108, 114, 160) comme composants de contrôle,
* un récipient (52, 124) parallélépipédique commun dans lequel sont disposés au moins lesdits composants de contrôle,
* un dispositif de déplacement (72, 112),
dans lequel
l'au moins une bobine à haute tension (68, 70, 108, 110, 160) peut être déplacée au moins partiellement hors du récipient (52, 124) à travers au moins une ouverture au niveau d'une surface de délimitation de celui-ci au moyen du dispositif de déplacement (72, 112), permettant ainsi un changement entre une première variante d'arrangement de la bobine à haute tension (68, 70, 108, 114, 160) à l'intérieur du récipient (52, 124) parallélépipédique et une deuxième variante d'arrangement avec une distance d'isolation suffisante pour réaliser le contrôle de tension alternative, **caractérisé en ce que** celui-ci comprend un dispositif de déplacement supplémentaire (116) et un diviseur de tension (86, 122, 162), lequel peut être déplacé au moins partiellement hors du récipient (52, 124) à travers au moins une ouverture supplémentaire au niveau d'une surface de délimitation de celui-ci au moyen du dispositif de déplacement supplémentaire (116).

2. Arrangement de contrôle selon la revendication 1, **caractérisé en ce que** l'au moins une ouverture et/ou l'au moins une ouverture supplémentaire se trouve(nt) à chaque fois sur une surface de délimitation verticale du récipient (52, 124) et le dispositif de déplacement (72, 112) et/ou le dispositif de déplacement supplémentaire (116) agi(ssen)t principalement dans la direction horizontale (74, 116).

3. Arrangement de contrôle selon la revendication 2, **caractérisé en ce que** le dispositif de déplacement (72, 112) et/ou le dispositif de déplacement supplémentaire (116) avec la bobine à haute tension (68, 70, 108, 110, 160) déplacée au moins partiellement hors du récipient (52, 124) ou avec le diviseur de tension (86, 122, 162) déplacé au moins partiellement hors du récipient peu(ven)t être soutenu(s) vers le bas au moyen d'un dispositif de soutien (80).

4. Arrangement de contrôle selon la revendication 1, **caractérisé en ce que** l'au moins une ouverture et/ou l'au moins une ouverture supplémentaire se trouve(nt) sur la surface de délimitation supérieure du récipient (52, 124) et le dispositif de déplacement (72, 112) et/ou le dispositif de déplacement supplémentaire (116) agi(ssen)t principalement dans la direction verticale (114).

5. Arrangement de contrôle selon l'une des revendications précédentes, **caractérisé en ce que** l'au moins une ouverture et/ou l'au moins une ouverture supplémentaire peu(ven)t être fermée(s).

6. Arrangement de contrôle selon l'une des revendications précédentes, **caractérisé en ce que** le dispositif de déplacement (72, 112) et/ou le dispositif de déplacement supplémentaire (116) est/sont muni(s) d'un mécanisme d'entraînement.

7. Arrangement de contrôle selon l'une des revendications précédentes, **caractérisé en ce que** le récipient (52, 124) est relié avec un dispositif de transport (102, 104) qui présente des roues (106) qui le portent.

8. Arrangement de contrôle selon l'une des revendications précédentes, **caractérisé en ce que** le récipient (52, 124) est un conteneur transportable ayant des dimensions standard.

9. Arrangement de contrôle selon l'une des revendications précédentes, **caractérisé en ce que** le récipient (52, 124) présente une zone intérieure (82) dans laquelle sont disposés des dispositifs de mesure et/ou des dispositifs d'interprétation (84).

10. Arrangement de contrôle selon l'une des revendications précédentes, **caractérisé en ce que** les composants de contrôle (54, 56, 58, 62, 64, 66, 68, 70, 86, 108, 110, 120, 122, 152, 158, 160, 162) sont au moins partiellement reliés électriquement entre eux au moyen de câbles à haute tension isolés.

11. Arrangement de contrôle selon l'une des revendications précédentes, **caractérisé en ce que** celui-ci comprend un circuit électrique oscillant à résonance (150) avec au moins la bobine à haute tension (68, 70, 108, 110, 160) et un composant à haute tension (172) à contrôler ainsi qu'un diviseur de tension (86, 120, 122, 162) connecté avec ceux-ci.

12. Arrangement de contrôle selon la revendication 1, **caractérisé en ce que** le circuit oscillant à résonance (100) peut être excité au moyen de l'onduleur (54, 152) et du transformateur de contrôle (58, 158) relié électriquement avec celui-ci.

13. Arrangement de contrôle selon l'une des revendications 1 ou 12, **caractérisé en ce que** la bobine à haute tension (88, 70, 108, 114, 180) présente au moins un conducteur électrique qui est disposé en une pluralité d'enroulements autour d'un axe d'enroulement, les enroulements entourant dans le sens radial un espace intérieur le long de l'axe d'enroulement et **en ce que** dans cet espace intérieur est disposé au moins un condensateur (164) par le biais duquel, conjointement avec au moins un condensateur (166) supplémentaire relié électriquement avec celui-ci, est réalisée la fonctionnalité du diviseur de tension (162).

14. Arrangement de contrôle selon l'une des revendications précédentes, **caractérisé en ce qu'**au moins une étape de procédé nécessaire pendant un processus de contrôle ou la totalité du processus de contrôle peut être initiée au moyen d'une commande à distance.
